# EUROPEAN PATENT SPECIFICATION

(11) **EP 3 886 543 B1**
(45) Date of publication and mention of the grant of the patent: **31.07.2024**
(21) Application number: 19905280.4
(22) Date of filing: 16.12.2019
(51) Int. Cl.: H05K 5/00, H05K 7/18, H04Q 1/02, A47B 47/00

(54) **METHOD FOR TRANSPORTING AND ASSEMBLING CABINET**
VERFAHREN ZUM TRANSPORTIEREN UND MONTIEREN EINES SCHRANKS
PROCÉDÉ DE TRANSPORT ET D'ASSEMBLAGE D'ARMOIRE

(30) Priority: 27.12.2018 CN 201811615178
(43) Date of publication of application: 29.09.2021
(73) Proprietor: Huawei Technologies Co., Ltd., Shenzhen Guangdong 518129 (CN)
(72) Inventor: YAN, Hongyu, Shenzhen, Guangdong 518129 (CN); LIANG, Wei, Shenzhen, Guangdong 518129 (CN); SHU, Siwen, Shenzhen, Guangdong 518129 (CN)
(74) Representative: Isarpatent
(86) International application number: PCT/CN2019/125492
(87) International publication number: WO 2020/135119

(56) References cited:
- CN-A- 1 852 643
- CN-A- 101 902 891
- CN-U- 201 690 692
- CN-U- 204 466 101
- CN-U- 207 780 314
- US-A1- 2004 239 215
- US-A1- 2014 146 483

## Description

### TECHNICAL FIELD

This invention relates to a mechanical apparatus in the electronic or communication field, and in particular, to an assembling method for transportation of a cabinet.

### BACKGROUND

A cabinet is usually an object made of a cold-rolled steel sheet or an alloy to store a computer and a related control device. The cabinet can protect the stored devices and shield electromagnetic interference, and the devices are orderly and neatly arranged in the cabinet. This facilitates future maintenance of the devices.

At present, a commonly used cabinet includes a main cabinet and a side cabinet. The cabinet is relatively large, and is usually used in an equipment room. A user expects that the cabinet and a subrack are preassembled to reduce an installation time during on-site construction. In addition, the user expects that a size of the cabinet can be reduced during transportation, to save an assembling material, improve transportation efficiency, and reduce transportation costs.

Currently, there are two assembling policies for the cabinet. A first policy is to package the cabinet based on the original size without extra assembling design. In this case, the cabinet does not need to be assembled on a construction site. However, a transportation size is extremely large and transportation costs are high during transportation. A second policy is to disassemble the cabinet and then package and transport the cabinet. The size of the packaged cabinet is greatly reduced, but the disassembled cabinet is extremely scattered and on-site installation takes a long time. In addition, the subrack cannot be installed in the cabinet for delivery together and needs to be assembled and transported separately. This policy reduces transportation efficiency and increases transportation costs from an overall perspective.

CN 207 780 314 U discloses a wiring cabinet including two wiring sub-cabinets each having doors wherein the two wiring sub-cabinets are connected through two connection members and four mounting plates. The wiring cabinet can be disassembled during transportation, and the wiring sub-cabinets and the connecting members are separately transported.

### SUMMARY

The object of the present invention is to provide an assembling method for transportation of a cabinet, to further effectively improve transportation efficiency and reduce transportation costs during cabinet assembling for transportation.

The present invention provides a cabinet. The cabinet includes a main cabinet and two side cabinets, the side cabinet includes a cabinet door, the cabinet door is detachable, the main cabinet includes a post and one or more subracks, the one or more subracks are installed on the post, the two side cabinets are connected to two sides of the main cabinet, and connections between the two side cabinets and the main cabinet are detachable.

According to an embodiment, the main cabinet further includes a buffer apparatus. The buffer apparatus is used to buffer the subrack to reduce vibration, and the buffer apparatus includes a foam plastic, a sponge, an elastic mechanical part, or a damper shock absorber.

According to an embodiment, the two side cabinets are connected to the main cabinet through screws.

According to an embodiment, each of the side cabinets further includes a spool post, and the spool post is used for optical fiber management.

According to an embodiment, a cabling channel, an optical cable clamp assembly, a corrugated pipe, and a velcro tape or a cable tie are arranged below the side cabinet. The cabling channel is used to cluster the cabinet, the optical cable clamp assembly is used to fasten an optical cable, the corrugated pipe is used to protect the optical cable, and the velcro tape or the cable tie is used to bind the optical cable.

According to an embodiment, the optical cable clamp assembly includes a sheet metal assembly; the sheet metal assembly includes a fastening plate, a fastening clip, or a stud; and the stud is used to fasten a strength member.

The present invention provides an assembling method for cabinet transportation. The cabinet includes a main cabinet and two side cabinets, the side cabinet includes a side door and a cabinet door, the side door and the cabinet door are detachable, the main cabinet includes a post and a subrack, the main cabinet is in a " 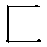 " shape in a side view, the two side cabinets are connected to two sides of the main cabinet, and connections between the two side cabinets and the main cabinet are detachable. The assembling method for cabinet transportation includes:
disassembling the connections between the two side cabinets and the main cabinet, where the disassembled main cabinet and the disassembled two side cabinets are independent of each other;
disassembling the side doors and the cabinet doors from the two side cabinets, where the side cabinet from which the side door and the cabinet door are disassembled is in a " C" shape in a side view;
placing side by side the two side cabinets from which the side doors and the cabinet doors are disassembled, and fixedly connecting the two side cabinets through a fixed connection apparatus; and
buckling, with the main cabinet together in a staggered mode, the two side cabinets from which the side doors and the cabinet doors are disassembled.

According to an embodiment, the two side cabinets are connected to the main cabinet through screws.

According to an embodiment, the main cabinet further includes a buffer apparatus. The buffer apparatus is used to buffer the subrack to reduce vibration.

According to an embodiment, the buffer apparatus further includes a foam plastic, a sponge, an elastic mechanical part, or a damper shock absorber.

According to an embodiment, the fixed connection apparatus includes a connection plate or a screw.

According to an embodiment, a cabling channel, an optical cable clamp assembly, a corrugated pipe, and a velcro tape or a cable tie are arranged on the lower part of the side cabinet. The cabling channel is used to cluster the cabinet, the optical cable clamp assembly is used to fasten an optical cable, the corrugated pipe is used to protect the optical cable, and the velcro tape or the cable tie is used to bind the optical cable.

According to an embodiment, the optical cable clamp assembly includes a sheet metal assembly; the sheet metal assembly includes a fastening plate, a fastening clip, or a stud; and the stud is used to fasten a strength member.

According to an embodiment, each of the side cabinets further includes a spool post, and the spool post is used for optical fiber management.

According to an embodiment, in actual transportation, the cabinet is placed horizontally, to prevent the main cabinet and the side cabinets that are buckled together from being separated due to other external force.

The present invention and its embodiments provide an assembling method for cabinet transportation. The cabinet does not need to be disassembled extremely scatteredly during transportation. After a cabinet structure is improved, the cabinet is disassembled into the main cabinet and the two side cabinets. The two side cabinets are fastened side by side, and are buckled with the main cabinet in a staggered mode. In this case, a transportation size of a product is reduced, and components originally installed inside the product can also be installed in the product for delivery together. This improves transportation efficiency and reduces transportation costs. In addition, an on-site installation time of the product is greatly reduced, a labor hour for on-site installation and on-site installation costs are reduced.

### BRIEF DESCRIPTION OF DRAWINGS

To describe technical solutions in embodiments of the present invention or in the conventional technology more clearly, the following briefly describes accompanying drawings used in describing the background and the embodiments. It is clear that the accompanying drawings in the following descriptions show merely some embodiments of the present invention, and a person of ordinary skill in the art may still derive other drawings or embodiments based on these drawings or descriptions without creative efforts, and the present invention is intended to cover all these derived drawings or embodiments.
FIG. 1 is a schematic diagram of a cabinet according to an embodiment of the present invention;
FIG. 2a is a front view of a main cabinet of a cabinet according to an embodiment of the present invention;
FIG. 2b is a side view of a main cabinet of a cabinet according to an embodiment of the present invention;
FIG. 3a is a front view of a side cabinet of a cabinet according to an embodiment of the present invention;
FIG. 3b is a side view of a side cabinet of a cabinet according to an embodiment of the present invention;
FIG. 4a is a flowchart of an assembling method for cabinet transportation according to an embodiment of the present invention;
FIG. 4b is a schematic diagram of transportation and assembly of a cabinet according to an embodiment of the present invention; and
FIG. 4c is a schematic diagram of a fixed connection apparatus of a cabinet according to an embodiment of the present invention.

### DESCRIPTION OF EMBODIMENTS

To make objectives, technical solutions, and advantages of the present invention clearer and more comprehensible, the following further describes the present invention in detail with reference to accompanying drawings and embodiments. It should be understood that the specific embodiments described herein are merely used to explain the present invention but are not intended to limit the present invention. It is clear that the described embodiments are merely some but not all of the embodiments of the present invention. All other embodiments obtained by a person of ordinary skill in the art based on the embodiments of the present invention without creative efforts shall fall within the protection scope of the present invention.

A first embodiment of the present invention provides a cabinet.

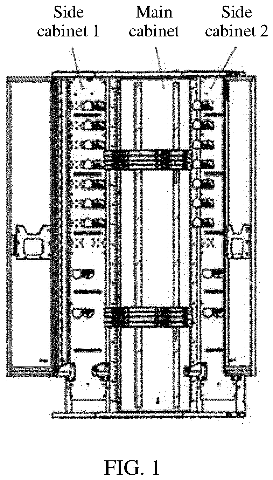

FIG. 1 is a schematic diagram of the cabinet according to the first embodiment of the present invention. As shown in FIG. 1, the cabinet includes a main cabinet, a side cabinet 1, and a side cabinet 2. Side doors and cabinet doors (the cabinet doors in FIG. 1 are open) are installed on the side cabinet 1 and the side cabinet 2. All of the side doors and the cabinet doors are detachable. The side cabinet 1 and the side cabinet 2 are installed on both sides of the main cabinet and are of a same height as the main cabinet. The main cabinet, the side cabinet 1, and the side cabinet 2 are connected to each other through a connection apparatus, and the fixed connection apparatus is detachable. A special optical fiber bobbin design is used for the cabinet. An optical fiber can enter any one of modules with a same length. In addition, a half-door design is used for the cabinet, so that the door does not need to be opened during cabling. Bending radii of all optical fibers in the cabinet are greater than or equal to 30 mm. Both the top and the bottom of the cabinet have cabling channels.

Further, the connection apparatus between the main cabinet and the side cabinets may be connected through screws.

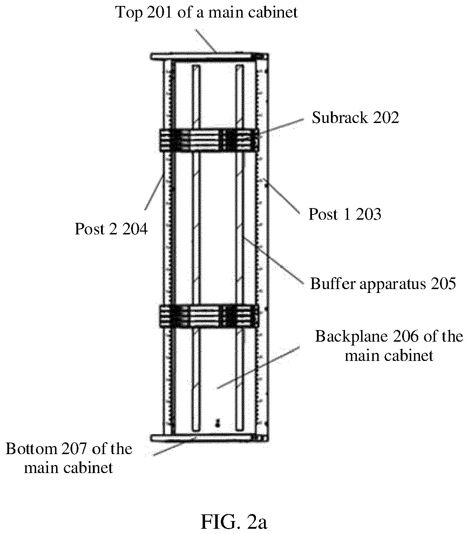

FIG. 2a is a front view of a main cabinet of the cabinet according to the first embodiment of the present invention. As shown in FIG. 2a, the main cabinet includes the top 201 of the main cabinet, a subrack 202, a post 1 203, a post 2 204, a buffer apparatus 205, a backplane 206 of the main cabinet, and the bottom 207 of the main cabinet. The post 1 203 is connected to the top 201 of the main cabinet and the bottom 207 of the main cabinet, and the post 2 204 is connected to the top 201 of the main cabinet and the bottom 207 of the main cabinet. On the post 1 203 and the post 2 204, there are equally spaced installation positions for installing one or more subracks. The subrack is used to connect and adjust optical fiber links.

Optionally, the buffer apparatus 205 is used to buffer an installed subrack to reduce vibration. The buffer apparatus may be a foam plastic, a sponge, an elastic mechanical part, a damper shock absorber, or the like.

The elastic mechanical part includes a spring. The spring is a part made of an elastic material. The spring deforms under an action of external force, and restores to an original state after the external force is removed. The spring includes a coil spring, a scroll spring, a leaf spring, a special-shaped spring, or the like.

The damper shock absorber is an apparatus that provides movement resistance and reduces movement energy, and uses damping to absorb energy and reduce vibration.

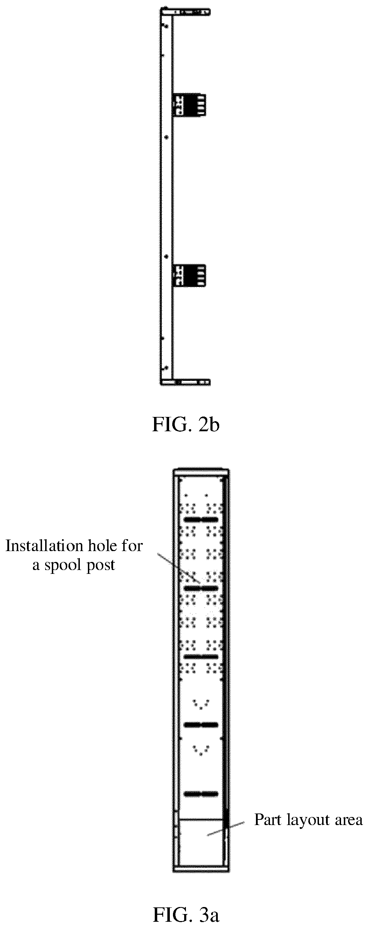

FIG. 2b is a side view of a main cabinet of a cabinet according to an embodiment of the present invention. As shown in FIG. 2b, the main cabinet is designed to be in a " 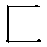 " shape in a side view, in other words, the main cabinet includes only three entity surfaces.

FIG. 3a is a front view of a side cabinet of a cabinet according to an embodiment of the present invention. Side cabinets include a side cabinet 1 and a side cabinet 2. As shown in FIG. 3a, the side cabinet is installed on a side of a main cabinet. The side cabinet includes installation holes for internal spool posts. The holes are used to install the spool posts. There is a part layout area on the lower part of the side cabinet.

Optionally, the spool post may be installed on the side cabinet, and the spool post is used to manage an extra length of a wire or an optical fiber, so as to manage the optical fiber.

Optionally, a cabling channel, an optical cable clamp assembly, a corrugated pipe, and a velcro tape or a cable tie may be arranged in the part layout area. The cabling channel is used to cluster the cabinet, the optical cable clamp assembly is used to fasten an optical cable, the corrugated pipe is used to protect the optical cable, and the velcro tape or the cable tie is used to bind the optical cable.

Specifically, the optical cable clamp assembly includes a sheet metal assembly. The sheet metal assembly includes a fastening plate, a fastening clip, or a stud. The stud is used to fasten a strength member.

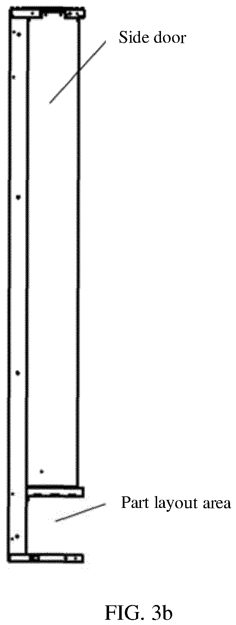

FIG. 3b is a side view of a side cabinet of a cabinet according to an embodiment of the present invention. Side cabinets include a side cabinet 1 and a side cabinet 2. As shown in FIG. 3b, the side cabinet is designed to be in a "E" shape in a side view. In other words, the side cabinet includes only three entity surfaces. The side cabinet includes a side door, and the side door is detachable.

A second embodiment of the present invention provides an assembling method for cabinet transportation that may be applied to the foregoing embodiment. This method is used to assemble a cabinet before packaging and transportation, to reduce a transportation size and improve transportation efficiency.

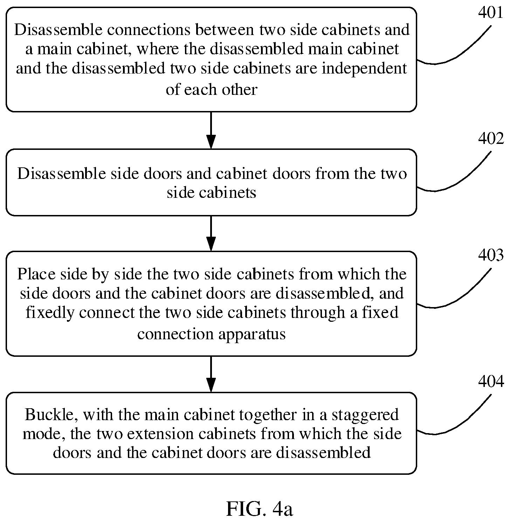

An assembling method for cabinet transportation is provided. The cabinet includes a main cabinet and two side cabinets. The side cabinet includes a side door and a cabinet door. The side door and the cabinet door are detachable. The main cabinet includes a post and a subrack. The main cabinet is in a " 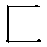 " shape in a side view. The two side cabinets are connected to two sides of the main cabinet. Connections between the two side cabinets and the main cabinet are detachable. The assembling method for cabinet transportation is shown in FIG. 4a, including the following steps:

Step 401: Disassemble the connections between the two side cabinets and the main cabinet, where the disassembled main cabinet and the disassembled two side cabinets are independent of each other.

Step 402: Disassemble the side doors and the cabinet doors from the two side cabinets, where the side cabinet from which the side door and the cabinet door are disassembled is in a " 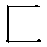 " shape in a side view.

Step 403: Place side by side the two side cabinets from which the side doors and the cabinet doors are disassembled, and fixedly connect the two side cabinets through a fixed connection apparatus.

Step 404: Buckle, with the main cabinet together in a staggered mode, the two side cabinets from which the side doors and the cabinet doors are disassembled.

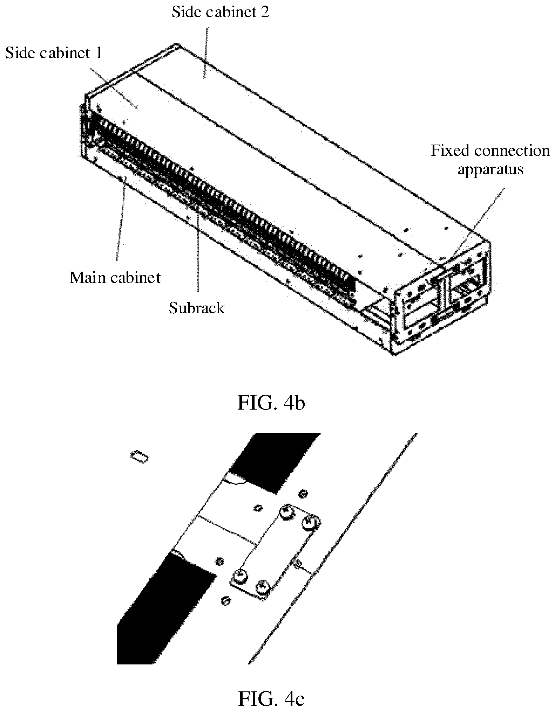

As shown in FIG. 4b, the side cabinet 1 and the side cabinet 2 are placed side by side, connected together through the fixed connection apparatus, and buckled together with the main cabinet in a staggered mode. A subrack is installed on the main cabinet, and the subrack is located between the main cabinet and the side cabinets.

Further, in actual transportation, the cabinet is placed horizontally as shown in FIG. 4b, to prevent the side cabinets and the main cabinet that are buckled together from being separated due to other external force.

The main cabinet further includes a buffer apparatus, and the buffer apparatus is used to buffer the subrack to reduce vibration.

Optionally, the buffer apparatus includes a foam plastic, a sponge, an elastic mechanical part, or a damper shock absorber. The elastic mechanical part includes a spring.

Specifically, the fixed connection apparatus includes a connection plate or screws. As shown in FIG. 4c, the connection plate is put on the two side cabinets, and the two side cabinets are connected together by tightening the screws.

Optionally, one of a velcro tape or a cable tie, a cabling channel, an optical cable clamp assembly, and a corrugated pipe are arranged on the lower part of the subrack. The velcro tape or the cable tie is used to bind an optical cable, the cabling channel is used to cluster the cabinet, the optical cable clamp assembly is used to fasten the optical cable, and the corrugated pipe is used to protect the optical cable.

Specifically, the optical cable clamp assembly includes a sheet metal assembly. The sheet metal assembly includes a fastening plate, a fastening clip, or a stud. The stud is used to fasten a strength member of the optical cable.

Optionally, the two side cabinets are connected to the main cabinet through screws.

Optionally, a spool post may be installed on the side cabinet, and the spool post is used to manage an extra length of a wire or an optical fiber, so as to manage the optical fiber.

The embodiments of the present invention provide the assembling method for cabinet transportation. The cabinet does not need to be disassembled extremely scatteredly during transportation. After a cabinet structure is improved, the cabinet is disassembled into the main cabinet and the two side cabinets. The two side cabinets are fastened side by side, and are buckled with the main cabinet in a staggered mode. In this case, a transportation size of a product is reduced, and components originally installed inside the product can also be installed in the product for delivery together. This improves transportation efficiency and reduces transportation costs. In addition, an on-site installation time of the product is greatly reduced, a labor hour for on-site installation and on-site installation costs are reduced.

The foregoing descriptions are merely specific implementations of this application, but are not intended to limit the protection scope of this application. Any variation or replacement readily figured out by a person skilled in the art within the technical scope disclosed in this application shall fall within the protection scope of this invention, which is defined by the appended claims.

Therefore, the protection scope of this application shall be subject to the protection scope of the claims.

## Claims

1. An assembling method for transportation of a cabinet, wherein the cabinet comprises a main cabinet and two side cabinets (1, 2), the respective side cabinet (1, 2) includes three entity surfaces, the three entity surfaces comprising a center surface and a top surface and a bottom surface extending from the center surface in a U-shape in a side view, the edges of the entity surfaces of the respective side cabinet defining a first and a second side of the respective side cabinet, and comprises a side door on the second side of the side cabinet, and a cabinet door, the side door and the cabinet door are detachable, the main cabinet comprises a post (203, 204) and a subrack, the main cabinet includes three entity surfaces with a backplane (206) and a top surface (201) and a bottom surface (207) extending from the backplane (206) in a U- shape in a side view, the edges of the entity surfaces of the main cabinet defining a first and a second side of the main cabinet, the two side cabinets (1, 2) are connected at their respective first side to the first and second side, respectively of the main cabinet, connections between the two side cabinets (1, 2) and the main cabinet are detachable, and the assembling method for cabinet transportation comprises:
disassembling (401) the connections between the two side cabinets (1, 2) and the main cabinet, wherein the disassembled main cabinet and the disassembled two side cabinets (1, 2) are independent of each other;
disassembling (402) the side doors and the cabinet doors from the two side cabinets (1, 2), wherein the side cabinet (1, 2) from which the side door and the cabinet door are disassembled is in its U- shape in the side view;
placing (403) side by side the two side cabinets (1, 2) from which the side doors and the cabinet doors are disassembled, such that a side of one side cabinet faces a side of the other side cabinet, and fixedly connecting the two side cabinets (1, 2) through a fixed connection apparatus; and
buckling (404), with the main cabinet together in a staggered mode, the two fixedly connected side cabinets (1, 2) from which the side doors and the cabinet doors are disassembled wherein the U-shaped main cabinet is received in the U-shaped fixedly connected side cabinets (1,2).

2. The method according to claim 1, wherein the main cabinet further comprises a buffer apparatus (205), and the buffer apparatus (205) is used to buffer the subrack to reduce vibration.

3. The method according to claim 2, wherein the buffer apparatus (204) comprises a foam plastic, a sponge, an elastic mechanical part, or a damper shock absorber; and the elastic mechanical part comprises a spring.

4. The method according to any one of claims 1-3, wherein the fixed connection apparatus comprises a connection plate or a screw.

5. The method according to any one of claims 1-4, wherein one of a velcro tape or a cable tie, a cabling channel, an optical cable clamp assembly, and a corrugated pipe are arranged below the subrack, the velcro tape or the cable tie is used to bind an optical cable, the cabling channel is used to cluster the cabinet, the optical cable clamp assembly is used to fasten the optical cable, and the corrugated pipe is used to protect the optical cable.

6. The method according to claim 5, wherein the optical cable clamp assembly comprises a sheet metal assembly, the sheet metal assembly comprises a fastening plate, a fastening clip, or a stud; and the stud is used to fasten a strength member of the optical cable.

7. The method according to any one of claims 1-6, wherein each of the two side cabinets (1, 2) further comprises a spool post, and the spool post is used for optical fiber management.

8. The method according to any one of claims 1-7, wherein the two side cabinets (1, 2) are connected to the main cabinet through screws.

## Patentansprüche

1. Montageverfahren zum Transport eines Schranks, wobei der Schrank einen Hauptschrank und zwei Seitenschränke (1, 2) umfasst, der jeweilige Seitenschrank (1, 2) drei Einheitsflächen umfasst, wobei die drei Einheitsflächen eine Mittelfläche und eine obere Fläche und eine untere Fläche umfassen, die sich von der Mittelfläche in einer Seitenansicht U-förmig erstrecken, wobei die Kanten der Gesamtflächen des jeweiligen Seitenschranks eine erste und eine zweite Seite des jeweiligen Seitenschranks definieren, und eine Seitentür auf der zweiten Seite des Seitenschranks und eine Schranktüre umfassen, wobei die Seitentür und die Schranktür abnehmbar sind, der Hauptschrank einen Pfosten (203, 204) und einen Einschub umfasst, der Hauptschrank drei Einheitenflächen mit einer Rückwandplatine (206) und einer oberen Fläche (201) und einer unteren Fläche (207) umfasst, die sich von der Rückwandplatine (206) in einer U-Form in einer Seitenansicht erstrecken, wobei die Kanten der Gesamtflächen des Hauptschranks eine erste und eine zweite Seite des Hauptschranks definieren, die beiden Seitenschränke (1, 2) an ihrer jeweiligen ersten Seite mit der ersten bzw. zweiten Seite des Hauptschranks verbunden sind, wobei die Verbindungen zwischen den beiden Seitenschränken (1, 2) und dem Hauptschrank abnehmbar sind und das Montageverfahren für den Schranktransport Folgendes umfasst:
Demontieren (401) der Verbindungen zwischen den beiden Seitenschränken (1, 2) und dem Hauptschrank, wobei der demontierte Hauptschrank und die zwei demontierten Seitenschränke (1, 2) unabhängig voneinander sind;
Demontieren (402) der Seitentüren und der Schranktüren von den zwei Seitenschränken (1, 2), wobei der Seitenschrank (1, 2), von dem die Seitentür und die Schranktür demontiert werden, in der Seitenansicht eine U-Form aufweist;
Platzieren (403) der zwei Seitenschränke (1, 2), von denen die Seitentüren und die Schranktüren demontiert werden, nebeneinander, so dass eine Seite des einen Seitenschranks einer Seite des anderen Seitenschranks zugewandt ist, und festes Verbinden der zwei Seitenschränke (1, 2) durch eine feste Verbindungsvorrichtung; und
Knicken (404), mit dem Hauptschrank zusammen in einem versetzten Modus, der beiden fest verbundenen Seitenschränke (1, 2), von denen die Seitentüren und die Schranktüren demontiert werden, wobei der U-förmige Hauptschrank in den U-förmigen fest verbundenen Seitenschränken (1, 2) aufgenommen ist.

2. Verfahren nach Anspruch 1, wobei der Hauptschrank außerdem eine Puffervorrichtung (205) umfasst und die Puffervorrichtung (205) zum Puffern des Einschubs verwendet wird, um Vibrationen zu reduzieren.

3. Verfahren nach Anspruch 2, wobei die Puffervorrichtung (204) einen Schaumstoff, einen Schwamm, ein elastisches mechanisches Teil oder einen Dämpferstoßdämpfer umfasst; und der elastische mechanische Teil eine Feder umfasst.

4. Verfahren nach einem der Ansprüche 1-3, wobei die feste Verbindungsvorrichtung eine Verbindungsplatte oder eine Schraube umfasst.

5. Verfahren nach einem der Ansprüche 1-4, wobei eines von einem Klettband oder einem Kabelbinder, einem Kabelkanal, einer optischen Kabelklemmenbauruppe und einem Wellrohr unterhalb des Einschubs, des Klettbands oder des Klettbands angeordnet wird, wobei der Kabelbinder zum Binden eines optischen Kabels dient, der Kabelkanal zum Bündeln des Schranks dient, die optische Kabelklemmenbaugruppe zum Befestigen des optischen Kabels dient und das Wellrohr zum Schutz des optischen Kabels dient.

6. Verfahren nach Anspruch 5, wobei die optische Kabelklemmenbaugruppe eine Blechbaugruppe umfasst, wobei die Blechbaugruppe eine Befestigungsplatte, einen Befestigungsclip oder einen Bolzen umfasst; und der Bolzen zur Befestigung eines Festigkeitselements des optischen Kabels dient.

7. Verfahren nach einem der Ansprüche 1-6, wobei jeder der zwei Seitenschränke (1, 2) weiterhin einen Spulenpfosten umfasst und der Spulenpfosten für das Glasfasermanagement verwendet wird.

8. Verfahren nach einem der Ansprüche 1-7, wobei die beiden Seitenschränke (1, 2) durch Schrauben mit dem Hauptschrank verbunden werden.

## Revendications

1. Procédé d'assemblage pour le transport d'une armoire, dans lequel l'armoire comprend une armoire principale et deux armoires latérales (1, 2), l'armoire latérale (1, 2) respective comprend trois surfaces d'entité, les trois surfaces d'entité comprenant une surface centrale et une surface supérieure et une surface inférieure s'étendant à partir de la surface centrale en forme de U dans une vue latérale, les bords des surfaces d'entité de l'armoire latérale respective définissant un premier et un second côté de l'armoire latérale respective, et comprend une porte latérale sur le second côté de l'armoire latérale, et une porte d'armoire, la porte latérale et la porte d'armoire sont détachables, l'armoire principale comprend un montant (203, 204) et un casier, l'armoire principale comprend trois surfaces d'entité avec un fond de panier (206) et une surface supérieure (201) et une surface inférieure (207) s'étendant à partir du fond de panier (206) en forme de U dans une vue latérale, les bords des surfaces d'entité de l'armoire principale définissant un premier et un second côté de l'armoire principale, les deux armoires latérales (1, 2) sont raccordées au niveau de leur premier côté respectif au premier et au second côté, respectivement de l'armoire principale, des raccordements entre les deux armoires latérales (1, 2) et l'armoire principale sont détachables, et le procédé d'assemblage pour le transport d'armoire comprend :
le désassemblage (401) des raccordements entre les deux armoires latérales (1, 2) et l'armoire principale, dans lequel l'armoire principale désassemblée et les deux armoires latérales (1, 2) désassemblées sont indépendantes l'une de l'autre ;
le désassemblage (402) des portes latérales et des portes d'armoire des deux armoires latérales (1, 2), dans lequel l'armoire latérale (1, 2) à partir de laquelle la porte latérale et la porte d'armoire sont désassemblées sont en forme de U dans la vue latérale ;
le placement (403) côte à côte des deux armoires latérales (1, 2) à partir desquelles les portes latérales et les portes d'armoire sont désassemblées, de sorte qu'un côté d'une armoire latérale fait face à un côté de l'autre armoire latérale, et le raccordement de manière fixe des deux armoires latérales (1, 2) par l'intermédiaire d'un appareil de raccordement fixe ; et
le flambage (404), avec l'armoire principale en quinconce, des deux armoires latérales raccordées de manière fixe (1, 2) à partir desquelles les portes latérales et les portes d'armoire sont désassemblées, dans lequel l'armoire principale en forme de U est reçue dans les armoires latérales (1, 2) raccordées de manière fixe en forme de U.

2. Procédé selon la revendication 1, dans lequel l'armoire principale comprend également un appareil tampon (205), et l'appareil tampon (205) est utilisé pour tamponner le casier afin de réduire les vibrations.

3. Procédé selon la revendication 2, dans lequel l'appareil tampon (204) comprend une mousse plastique, une éponge, une pièce mécanique élastique, ou un amortisseur absorbeur de choc ; et la pièce mécanique élastique comprend un ressort.

4. Procédé selon l'une quelconque des revendications 1 à 3, dans lequel l'appareil de raccordement fixe comprend une plaque de raccordement ou une vis.

5. Procédé selon l'une quelconque des revendications 1 à 4, dans lequel un élément parmi une bande Velcro ou un serre-câble, un canal de câblage, un ensemble serre-câble optique et un tuyau ondulé sont agencés sous le casier, la bande Velcro ou le serre-câble est utilisé(e) pour attacher un câble optique, le canal de câblage est utilisé pour regrouper l'armoire, l'ensemble serre-câble optique est utilisé pour fixer le câble optique et le tuyau ondulé est utilisé pour protéger le câble optique.

6. Procédé selon la revendication 5, dans lequel l'ensemble serre-câble optique comprend un ensemble en tôle, l'ensemble en tôle comprend une plaque de fixation, un clip de fixation, ou un goujon ; et le goujon est utilisé pour fixer un élément de renforcement du câble optique.

7. Procédé selon l'une quelconque des revendications 1 à 6, dans lequel chacune des deux armoires latérales (1, 2) comprend également un montant de bobine, et le montant de bobine est utilisé pour la gestion de fibres optiques.

8. Procédé selon l'une quelconque des revendications 1 à 7, dans lequel les deux armoires latérales (1, 2) sont raccordées à l'armoire principale par l'intermédiaire de vis.
